# EUROPEAN PATENT APPLICATION

(11) **EP 4 369 412 A1**
(43) Date of publication of application: **15.05.2024**
(21) Application number: 23156290.1
(22) Date of filing: 13.02.2023
(51) Int. Cl.: H01L 29/423, H01L 21/8234, H01L 29/78, H01L 21/336, H01L 21/28

(54) **SEMICONDUCTOR DEVICE AND METHOD FOR FABRICATING THE SAME**

(30) Priority: 14.11.2022 CN 202211424068
(71) Applicant: United Microelectronics Corp., Hsin-Chu City 300 (TW)
(72) Inventor: CHANG, Chu-Chun, Kaohsiung City 804 (TW); VERMA, Purakh Raj, Singapore 757407 (SG); LIN, Chia-Huei, Hsinchu City 300 (TW); YANG, Kuo-Yuh, Zhubei City, Hsinchu County 302 (TW)
(74) Representative: Isarpatent

(57) **Abstract**

A method for fabricating semiconductor device includes first providing a substrate having a core region, a LNA region, a I/O region, and a PA region, forming a first gate structure on the LNA region, a second gate structure on the PA region, a third gate structure on the core region, and a fourth gate structure on the I/O region, forming an interlayer dielectric (ILD) layer on the first gate structure, the second gate structure, the third gate structure, and the fourth gate structure, and then forming a first hard mask on the first gate structure and a second hard mask on the second gate structure. Preferably, a width of the first hard mask is greater than a width of the first gate structure.

## Description

### Background of the Invention

### 1. Field of the Invention

The invention relates to a method for fabricating semiconductor device, and more particularly, to a method of forming hard mask on gate structures.

### 2. Description of the Prior Art

In current semiconductor industry, polysilicon has been widely used as a gap-filling material for fabricating gate electrode of metal-oxide-semiconductor (MOS) transistors. However, the conventional polysilicon gate also faced problems such as inferior performance due to boron penetration and unavoidable depletion effect which increases equivalent thickness of gate dielectric layer, reduces gate capacitance, and worsens driving force of the devices. In replacing polysilicon gates, work function metals have been developed to serve as a control electrode working in conjunction with high-K gate dielectric layers.

However, in current fabrication of high-k metal gate transistors, low noise amplifier (LNA) devices typically have shortcomings such as high minimum noise figure and gate to body capacitance. Hence, how to improve the current process for resolving this issue has become an important task in this field.

### Summary of the Invention

According to an embodiment of the present invention, a method for fabricating semiconductor device includes first providing a substrate having a core region, a LNA region, a I/O region, and a PA region, forming a first gate structure on the LNA region, a second gate structure on the PA region, a third gate structure on the core region, and a fourth gate structure on the I/O region, forming an interlayer dielectric (ILD) layer on the first gate structure, the second gate structure, the third gate structure, and the fourth gate structure, and then forming a first hard mask on the first gate structure and a second hard mask on the second gate structure. Preferably, a width of the first hard mask is greater than a width of the first gate structure.

According to another aspect of the present invention, a semiconductor device includes a first gate structure on a substrate, an interlayer dielectric (ILD) layer on the first gate structure, and a first hard mask on the first gate structure. Preferably, a width of the first hard mask is greater than a width of the first gate structure.

These and other objectives of the present invention will no doubt become obvious to those of ordinary skill in the art after reading the following detailed description of the preferred embodiment that is illustrated in the various figures and drawings.

### Brief Description of the Drawings

Figs. 1-6 illustrate a method for fabricating a semiconductor device according to an embodiment of the present invention.
Fig. 7 illustrates a structural view of a semiconductor device according to an embodiment of the present invention.
Fig. 8 illustrates a structural view of a semiconductor device according to an embodiment of the present invention.
Fig. 9 illustrates a structural view of a semiconductor device according to an embodiment of the present invention.
Fig. 10 illustrates a structural view of a semiconductor device according to an embodiment of the present invention.
Fig. 11 illustrates a structural view of a semiconductor device according to an embodiment of the present invention.
Fig. 12 illustrates a top view of a semiconductor device according to an embodiment of the present invention.

### Detailed Description

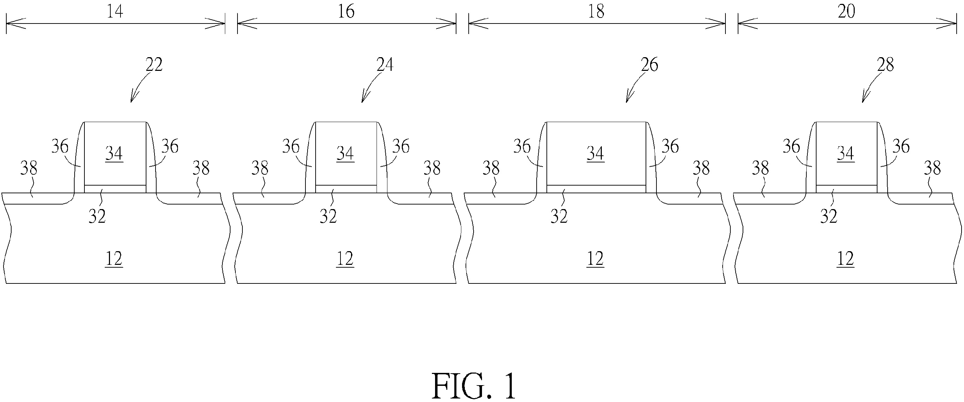

Referring to Figs. 1-6, Figs. 1-6 illustrate a method for fabricating a semiconductor device according to an embodiment of the present invention. As shown in Fig. 1, a substrate 12, such as a silicon substrate or silicon-on-insulator (SOI) substrate is provided and four regions including a core region 14, a low noise amplifier (LNA) region 16, an input/output (I/O) region 18, and a power amplifier (PA) region 20 are defined on the substrate 12. Preferably, at least a field effect transistor (FET) such as a MOS transistor or complimentary metal-oxide semiconductor (CMOS) transistor could be fabricated on each of the regions 14, 16, 18, 20, and then part of the substrate 12 could be removed and insulating material such as silicon oxide is deposited to form a shallow trench isolation (STI) (not shown) for separating the four regions 14, 16, 18, 20. It should be noted that even though this embodiment pertains to fabricate planar devices, according to other embodiment of the present invention, it would also be desirable to apply the process of this embodiment to fabricate non-planar devices such as fin field effect transistors (FinFET), which is also within the scope of the present invention.

According to an embodiment of the present invention, if a FinFET were to be fabricated, the fin-shaped structure could be obtained by a sidewall image transfer (SIT) process. For instance, a layout pattern is first input into a computer system and is modified through suitable calculation. The modified layout is then defined in a mask and further transferred to a layer of sacrificial layer on a substrate through a photolithographic and an etching process. In this way, several sacrificial layers distributed with a same spacing and of a same width are formed on a substrate. Each of the sacrificial layers may be stripe-shaped. Subsequently, a deposition process and an etching process are carried out such that spacers are formed on the sidewalls of the patterned sacrificial layers. In a next step, sacrificial layers can be removed completely by performing an etching process. Through the etching process, the pattern defined by the spacers can be transferred into the substrate underneath, and through additional fin cut processes, desirable pattern structures, such as stripe patterned fin-shaped structures could be obtained.

Alternatively, the fin-shaped structure could also be obtained by first forming a patterned mask (not shown) on the substrate, 12, and through an etching process, the pattern of the patterned mask is transferred to the substrate 12 to form the fin-shaped structure. Moreover, the formation of the fin-shaped structure could also be accomplished by first forming a patterned hard mask (not shown) on the substrate 12, and a semiconductor layer composed of silicon germanium is grown from the substrate 12 through exposed patterned hard mask via selective epitaxial growth process to form the corresponding fin-shaped structure. These approaches for forming fin-shaped structure are all within the scope of the present invention.

Next, at least a dummy gate or gate structures 22, 24, 26, 28 are formed on the substrate 12 of each of the four regions 14, 16, 18, 20. In this embodiment, the formation of the gate structures 22, 24, 26, 28 could be accomplished by sequentially depositing a gate dielectric layer 32, a gate material layer 34, and a selective hard mask (not shown) on the substrate 12, conducting a pattern transfer process by using a patterned resist (not shown) as mask to remove part of the gate material layer 34 and part of the gate dielectric layer 32, and then stripping the patterned resist to form dummy gates or gate structures 22, 24, 26, 28 on the substrate 12. Each of the gate structures 22, 24, 26, 28 preferably includes a patterned gate dielectric layer 32 and a patterned material layer 34, in which the gate dielectric layer 32 includes silicon oxide and the gate material layer 34 includes polysilicon, but not limited thereto.

Next, at least a spacer 36 is formed on sidewalls of each of the gate structures 22, 24, 26, 28, a source/drain regions 38 and/or epitaxial layers (not shown) are formed in the substrate 12 adjacent to two sides of the spacers 36, and a selective silicide (not shown) is formed on the surface of the source/drain regions 38 and/or epitaxial layers. In this embodiment, each of the spacers 36 could be a single spacer or a composite spacer. For instance, each of the spacers 36 could further include an offset spacer (not shown) and a main spacer (not shown), and the spacers 36 could be selected from the group consisting of SiO₂, SiN, SiON, and SiCN. The source/drain regions 38 and epitaxial layer could include different dopants or different material depending on the type of transistor being fabricated. For instance, the source/drain regions 38 could include p-type or n-type dopants and the epitaxial layers could include SiGe, SiC, or SiP.

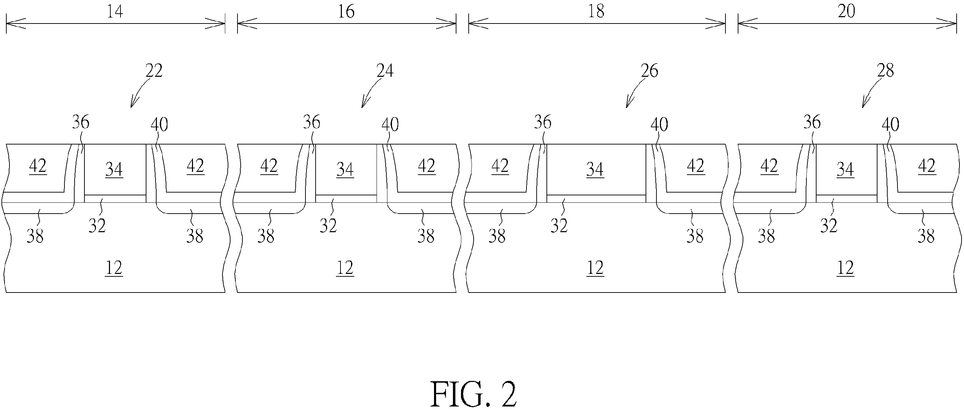

Next, as shown in Fig. 2, a contact etch stop layer (CESL) 40 is formed on the substrate 12 to cover the gate structures 22, 24, 26, 28 and then an interlayer dielectric (ILD) layer 42 is formed on the CESL 40. Next, a planarizing process such as a chemical mechanical polishing (CMP) process is conducted to remove part of the ILD layer 42 and part of the CESL 40 to expose the patterned material layer 34 made of polysilicon so the top surfaces of the patterned material layer 34 and ILD layer 42 are coplanar. In this embodiment, the CESL 40 could include silicon nitride while the ILD layer 42 could include silicon oxide, but not limited thereto.

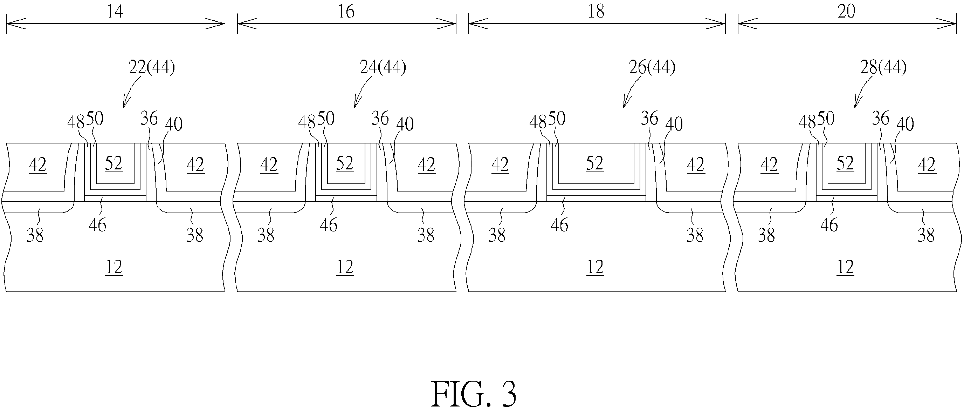

Next, as shown in Fig. 3, a replacement metal gate (RMG) process is conducted to transform the gate structures 22, 24, 26, 28 into metal gates 44. For instance, the RMG process could be accomplished by first performing a selective dry etching or wet etching process using etchants including but not limited to for example ammonium hydroxide (NH₄OH) or tetramethylammonium hydroxide (TMAH) to remove the gate material layer 34 and even the gate dielectric layer 32 for forming recesses (not shown) in the ILD layer 42. Next, an interfacial layer 46, a high-k dielectric layer 48, a work function metal layer 50, and a low resistance metal layer 52 are formed in the recesses, and a planarizing process such as CMP is conducted to remove part of low resistance metal layer 52, part of work function metal layer 50, and part of high-k dielectric layer 48 to form metal gates 44. In this embodiment, each of the gate structures 22, 24, 26, 28 or metal gates 44 fabricated through high-k last process of a gate last process preferably includes an interfacial layer 46 or gate dielectric layer, a U-shaped high-k dielectric layer 48, a U-shaped work function metal layer 50, and a low resistance metal layer 52. According to an embodiment of the present invention, part of the low resistance metal layer 52, part of the work function metal layer 50, and part of the high-k dielectric layer 48 could be removed thereafter to form recesses, a hard mask (not shown) is formed in each of the recesses, and a planarizing process such as CMP is conducted to remove part of the hard mask so that the top surfaces of the hard mask and ILD layer 42 are coplanar, which is also within the scope of the present invention.

In this embodiment, the high-k dielectric layer 48 is preferably selected from dielectric materials having dielectric constant (k value) larger than 4. For instance, the high-k dielectric layer 48 may be selected from hafnium oxide (HfO₂), hafnium silicon oxide (HfSiO₄), hafnium silicon oxynitride (HfSiON), aluminum oxide (Al₂O₃), lanthanum oxide (La₂O₃), tantalum oxide (TaiOs), yttrium oxide (Y₂O₃), zirconium oxide (ZrO₂), strontium titanate oxide (SrTiO₃), zirconium silicon oxide (ZrSiO₄), hafnium zirconium oxide (HfZrO₄), strontium bismuth tantalate (SrBi₂Ta₂O₉, SBT), lead zirconate titanate (PbZrₓTi₁₋ₓO₃, PZT), barium strontium titanate (BaₓSr₁₋ₓTiO₃, BST) or a combination thereof.

In this embodiment, the work function metal layer 50 is formed for tuning the work function of the metal gate in accordance with the conductivity of the device. For an NMOS transistor, the work function metal layer 50 having a work function ranging between 3.9 eV and 4.3 eV may include titanium aluminide (TiAl), zirconium aluminide (ZrAl), tungsten aluminide (WAl), tantalum aluminide (TaAl), hafnium aluminide (HfAl), or titanium aluminum carbide (TiAlC), but it is not limited thereto. For a PMOS transistor, the work function metal layer 50 having a work function ranging between 4.8 eV and 5.2 eV may include titanium nitride (TiN), tantalum nitride (TaN), tantalum carbide (TaC), but it is not limited thereto. An optional barrier layer (not shown) could be formed between the work function metal layer 50 and the low resistance metal layer 52, in which the material of the barrier layer may include titanium (Ti), titanium nitride (TiN), tantalum (Ta) or tantalum nitride (TaN). Furthermore, the material of the low-resistance metal layer 52 may include copper (Cu), aluminum (Al), titanium aluminum (TiAl), cobalt tungsten phosphide (CoWP) or any combination thereof.

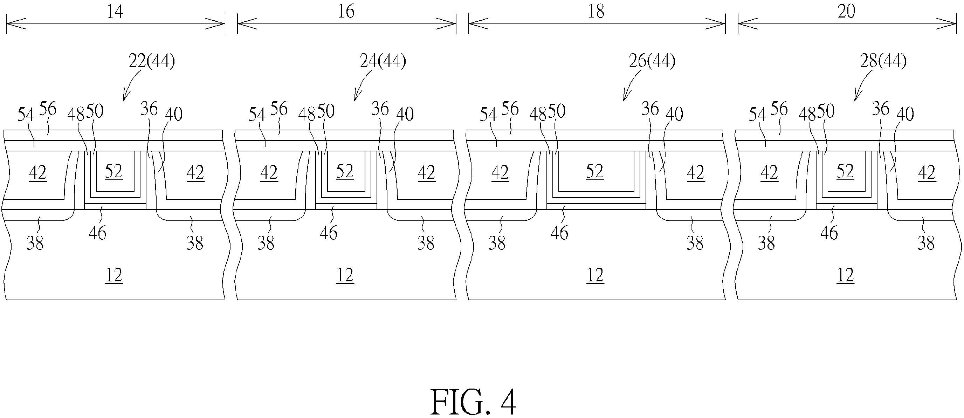

Next, as shown in Fig. 4, a hard mask 54 and another hard mask 56 are sequentially formed on the ILD layer 42 to cover the gate structures 22, 24, 26, 28. In this embodiment, the hard mask 54 is preferably made of metal nitride such as TiN while the hard mask 56 is made of dielectric material such as silicon nitride.

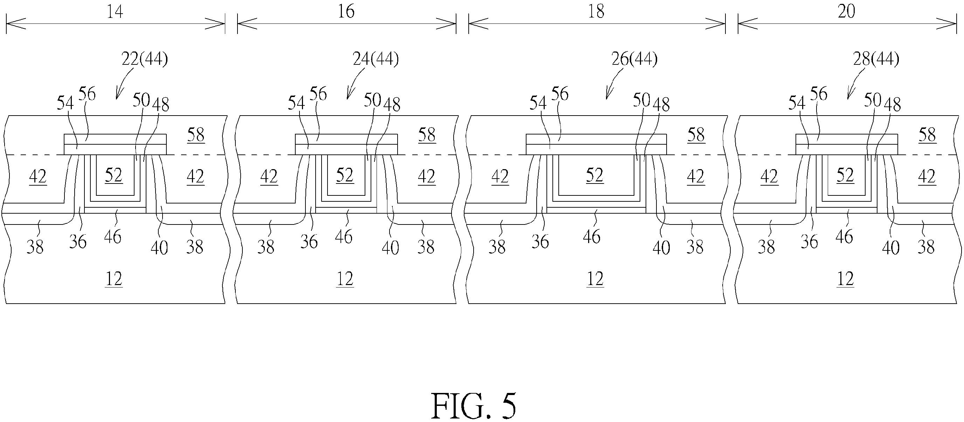

Next, as shown in Fig. 5, a photo-etching process is conducted to remove part of the hard masks 54, 56 so that the width of the remaining or patterned hard masks 54, 56 is slightly greater than the width of each of the gate structures 22, 24, 26, 28 and sidewalls of the hard mask 54 are aligned with sidewalls of the hard mask 56. Next, another ILD layer 58 is formed on the ILD layer 42 to cover the hard mask 56. In this embodiment, the ILD layer 42 and the ILD layer 58 could be made of same or different material including but not limited to for example silicon oxide such as tetraethyl orthosilicate (TEOS).

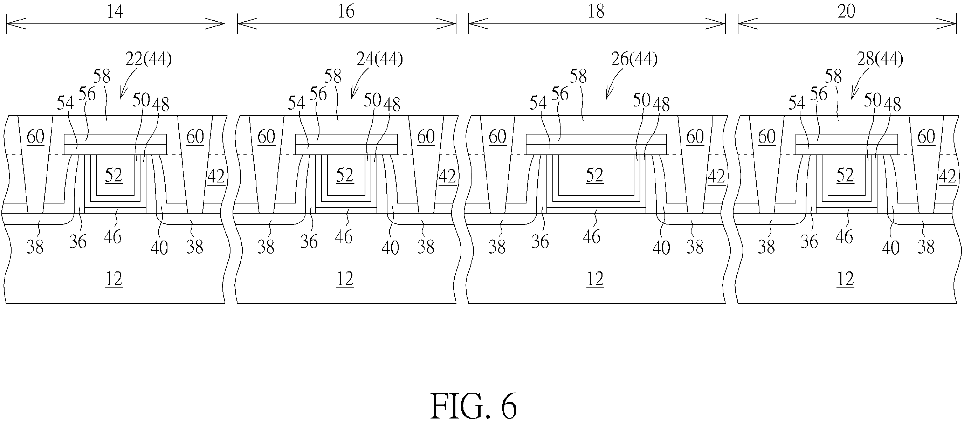

Next, as shown in Fig. 6, a contact plug formation could be conducted to form contact plugs 60 electrically connected to the source/drain regions 38 and/or gate structures 22, 24, 26, 28. In this embodiment, the formation of contact plugs 60 could be accomplished by removing part of the ILD layers 42, 58 and part of the CESL 40 to form contact holes (not shown), and then depositing a barrier layer (not shown) and a metal layer into the contact holes. A planarizing process, such as CMP is then conducted to remove part of the metal layer, part of the barrier layer, and even part of the ILD layer 58 to form contact plugs 60, in which the top surface of the contact plugs 60 is even with the top surface of the ILD layer 58. In this embodiment, the barrier layer is selected from the group consisting of Ti, Ta, TiN, TaN, and WN, and the metal layer is selected from the group consisting of Al, Ti, Ta, W, Nb, Mo, and Cu. This completes the fabrication of a semiconductor device according to an embodiment of the present invention.

Referring to Figs. 6-8, Figs. 6-8 illustrate structural views of a semiconductor device according to different embodiments of the present invention. As show in Fig. 6, the semiconductor device preferably includes a gate structure 22 disposed on the core region 14, a gate structure 24 disposed on the LNA region 16, a gate structure 26 disposed on the I/O region 18, a gate structure 28 disposed on the PA region 20, source/drain regions 38 disposed in the substrate 12 adjacent to two sides of the gate structures 22, 24, 26, 28, a CESL 40 disposed adjacent to two sides of the spacers 36, and hard masks 54 and 56 disposed on each of the gate structures 22, 24, 26, 28.

In this embodiment, the size such as width of the gate structure 26 on the I/O region 18 is slightly greater than the width of each of the gate structures 22, 24, 28 on the other three regions and the width of each of the hard masks 54, 56 is also slightly greater than the width of each of the gate structures 22, 24, 26, 28. Specifically, the width of each of the hard masks 54, 56 is greater than the distance or width measured from left sidewall of each of the gate structures 22, 24, 26, 28 to the right sidewall of each of the gate structures 22, 24, 26, 28, the left and/or right sidewalls of each of the hard masks 54, 56 could be aligned with outer sidewalls of each of the spacers 36, aligned with outer sidewalls of the CESL40, or surpassing outer sidewalls of the CESL40 adjacent to two sides of the gate structures 22, 24, 26, 28, which are all within the scope of the present invention.

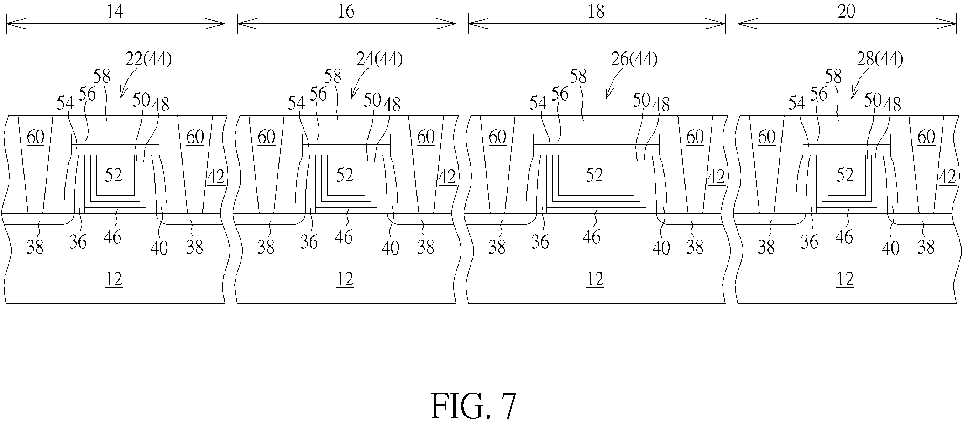

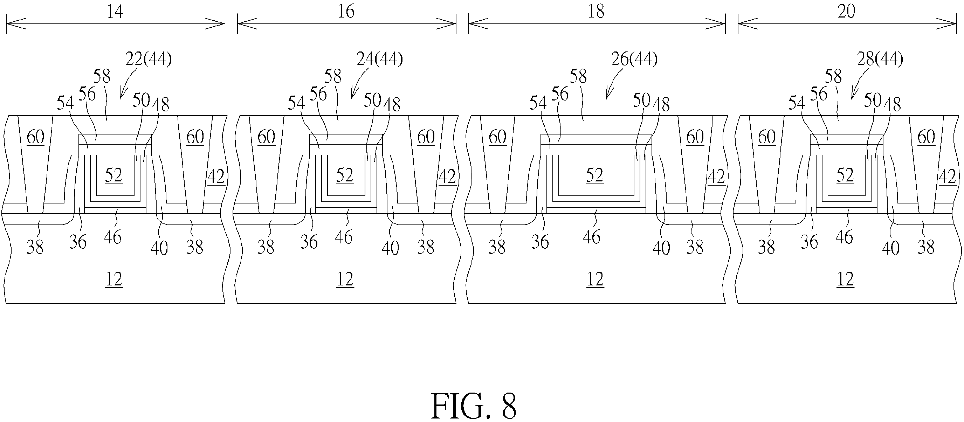

Referring to the hard mask 54, 56 disposed on the core region 14 for example, the width of each of the hard masks 54, 56 could be greater than the width of the gate structure 22 while the left sidewalls of the hard mask 54, 56 surpassing the left sidewall of the CESL 40 on left side of the gate structure 22 and the right sidewalls of the hard masks 54, 56 surpassing the right sidewall of the CESL 40 on right side of the gate structure 22. According to another embodiment of the present invention, as shown in Fig. 7, the width of each of the hard masks 54, 56 could be greater than the width of the gate structure 22 while the left sidewalls of the hard masks 54, 56 are aligned with left sidewall of the CESL 40 on left side of the gate structure 22 and the right sidewalls of the hard mask 54, 56 are aligned with right sidewall of the CESL 40 on right side of the gate structure 22. According to yet another embodiment of the present invention, as shown in Fig. 8, the width of each of the hard masks 54, 56 could be greater than the width of the gate structure 22 while the left sidewalls of the hard masks 54, 56 are aligned with left sidewall of the spacer 36 on left side of the gate structure 22 and the right sidewalls of the hard mask 54, 56 are aligned with right sidewall of the spacer 36 on right side of the gate structure 22, which are all within the scope of the present invention.

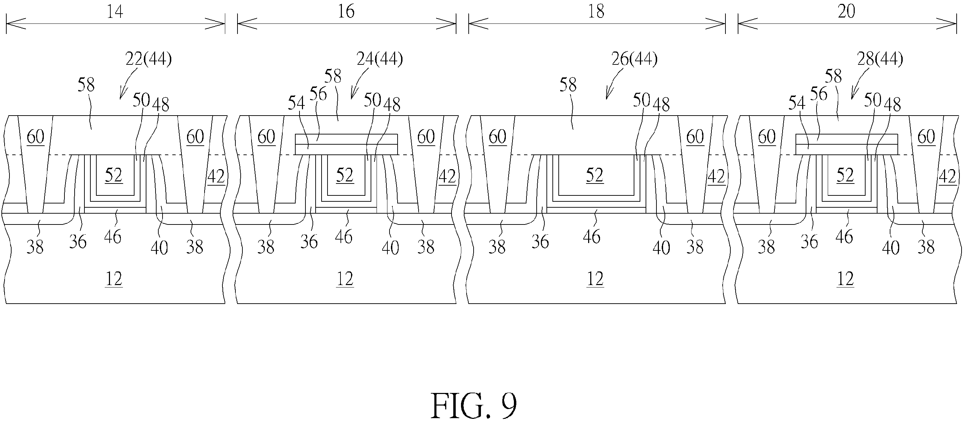

Referring to Fig. 9, Fig. 9 illustrates a structural view of a semiconductor device according to an embodiment of the present invention. As shown in Fig. 9, in contrast to forming hard masks 54, 56 on all four gate structures 22, 24, 26, 28 of the core region 14, the LNA region 16, the I/O region 18, and the PA region 20 in the aforementioned embodiment, it would also be desirable to adjust the patterning process conducted in Figs. 4-5 by forming hard masks 54, 56 only on the gate structures 24, 28 of the LNA region 16 and the PA region 20 while no hard mask is formed on the gate structures 22, 26 of the core region 14 and the I/O region 18 whatsoever. Preferably, the width of each of the hard masks 54, 56 is also greater than the width of the gate structures 24, 28. In other words, in contrast to the top surface of the gate structures 24, 28 on LNA region 16 and PA region 20 directly contacting the hard masks 54, 56, the top surface of the gate structures 22, 26 on the core region 14 and I/O region 18 preferably contacts the ILD layer 58 directly.

It should be noted that even though the left and right sidewalls of the hard masks 54, 56 in this embodiment are surpassing left and right sidewalls of the CESLs 40 on two adjacent sides as disclosed in Fig. 6, according to other embodiment of the present invention, the widths of the hard masks 54, 56 could also be adjusted according to the ones shown in Figs. 7 and 8 such that the left and right sidewalls of the hard masks 54, 56 could be aligned with left and right sidewalls of the CESL 40 or spacers 36 underneath, which are all within the scope of the present invention.

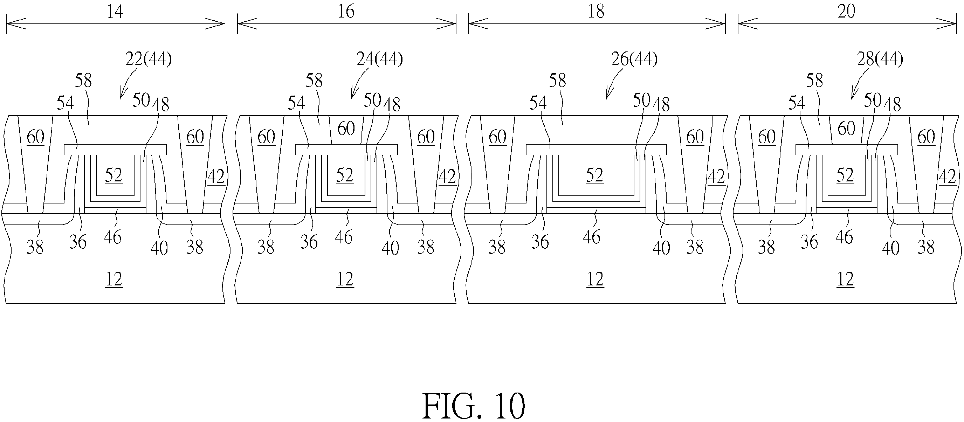

Referring to Fig. 10, Fig. 10 illustrates a structural view of a semiconductor device according to an embodiment of the present invention. As shown in Fig. 10, in contrast to forming dual hard masks 54, 56 on all of the gate structures 22, 24, 26, 28 in the core region 14, the LNA region 16, the I/O region 18, and the PA region 20, it should also be desirable to only form a single hard mask 54 on each of the gate structures 22, 24, 26, 28 while the hard mask 54 is preferably made of metal nitride such as TiN instead of dielectric material, which is also within the scope of the present invention.

Moreover, even though the left and right sidewalls of the single hard mask 54 in this embodiment also surpasses the left and right sidewalls of the CESL 40 adjacent to the gate structures 24, 28 as disclosed in Fig. 6, according to other embodiment of the present invention, the width of the hard mask 54 in this embodiment could also be adjusted according to the widths of the hard mask 54, 56 shown in Figs. 7-8 such that the left and right sidewalls of the single hard mask 54 could be aligned with left and right sidewalls of the CESL 40 or spacers 36 underneath, which is also within the scope of the present invention.

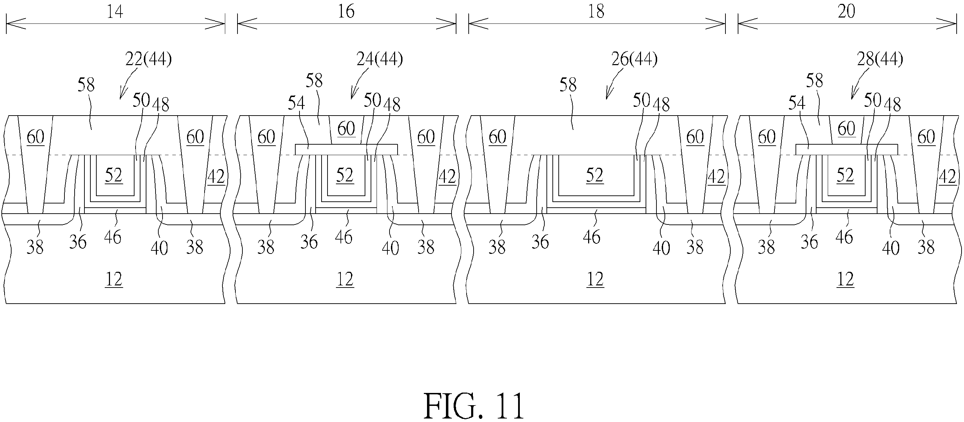

Referring to Fig. 11, Fig. 11 illustrates a structural view of a semiconductor device according to an embodiment of the present invention. As shown in Fig. 11, it would also be desirable to combine the embodiments shown in Figs. 9-10 by forming a single hard mask 54 on each of the gate structures 24, 28 on the LNA region 16 and PA region 20 but not forming any hard mask on the gate structures 22, 26 on the core region 14 and I/O region 18, which is also within the scope of the present invention.

Similarly, even though the left and right sidewalls of the single hard mask 54 in this embodiment also surpasses the left and right sidewalls of the CESL 40 adjacent to the gate structures 24, 28 as disclosed in Fig. 6, according to other embodiment of the present invention, the width of the hard mask 54 in this embodiment could also be adjusted according to the widths of the hard mask 54, 56 shown in Figs. 7-8 such that the left and right sidewalls of the single hard mask 54 could be aligned with left and right sidewalls of the CESL 40 or spacers 36 underneath, which is also within the scope of the present invention.

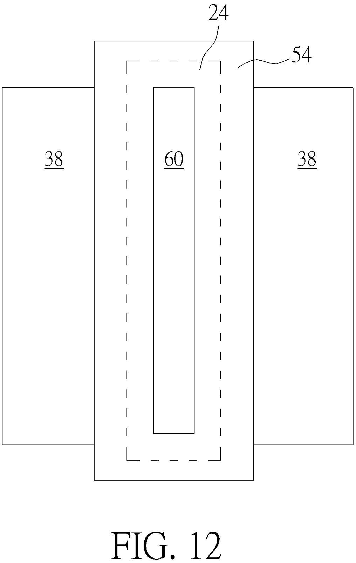

Referring to Fig. 12, Fig. 12 illustrates a top view of a semiconductor device according to an embodiment of the present invention. As shown in Fig. 11, first referring to the contact plug 60 disposed directly on top of the gate structure 24 as an example, the covering area or landing area of the contact plug 60 is preferably less than and without exceeding the top surface of the hard mask 54 and gate structure 24 underneath. Specifically, the top surface or bottom surface of the contact plug 60 is preferably less than the top surface of the gate structure 24 while the four sidewalls or four edges of the contact plug 60 preferably not surpassing the four sidewalls or four edges of the gate structure 24. In the meantime, the top surface of the gate structure 24 is also less than the top surface of the hard mask 24 while the four sidewalls or four edges of the gate structure 24 not surpassing four sidewalls or four edges of the hard mask 54, which are all within the scope of the present invention.

Overall, the present invention first conducts a RMG process to transform polysilicon gates into metal gates and then forms at least a hard mask having width greater than each of the metal gates on all or part of the gate structures such as the ones on the LNA region and PA region. Preferably, the hard mask could be used as an extension for the gate structures such that a combination of the hard mask and metal gate altogether could constitute a gate structure having a substantially T-shape cross-section while the hard mask atop each of the metal gates could be a dual-layer structure made of metal nitride and dielectric material or a single-layered structure made of metal nitride. Typically, current LNA devices have shortcomings such as high minimum noise figure and gate to body capacitance. By using the aforementioned hard mask or hard masks to increase the overall extending area of the gate structure, it would be desirable to obtain a much better maximum oscillation frequency (fmax) and current gain under low current environment thereby improving performance of the device.

## Claims

1. A method for fabricating a semiconductor device, comprising:
forming a first gate structure (24) on a substrate (12);
forming an interlayer dielectric, ILD, layer (42) on the first gate structure; and
forming a first hard mask (54) on the first gate structure, wherein a width of the first hard mask is greater than a width of the first gate structure.

2. The method of claim 1, wherein the substrate (12) comprises a core region (14), a low noise amplifier, LNA, region (16), an input/output, I/O, region (18), and a power amplifier, PA, region (20), the method further comprising:
forming the first gate structure (24) on the LNA region (16), a second gate structure (28) on the PA region (20), a third gate structure (22) on the core region (14), and a fourth gate structure (26) on the I/O region (16);
forming the ILD layer (42) on the first gate structure (24), the second gate structure (28), the third gate structure (22), and the fourth gate structure (26);
performing a replacement metal gate, RMG, process to transform the first gate structure (24), the second gate structure (28), the third gate structure (22), and the fourth gate structure (26) into a first metal gate, a second metal gate, a third metal gate, and a fourth metal gate; and
forming the first hard mask (54) on the first gate structure (24) and a second hard mask on the second gate structure (28).

3. The method of claim 2, further comprising:
forming a first contact etch stop layer, CESL, adjacent to one side of the first gate structure (24) and a second CESL adjacent to another side of the first gate structure (24) before performing the RMG process.

4. The method of claim 3, wherein the width of the first hard mask (54) is greater than a distance between the first CESL to the second CESL.

5. The method of claim 2, further comprising:
forming a third hard mask on the first hard mask (54) and a fourth hard mask on the second hard mask.

6. The method of claim 5, wherein a width of the first hard mask (54) is equal to a width of the third hard mask.

7. The method of claim 2, further comprising:
forming a third CESL adjacent to one side of the third gate structure (22) and a fourth CESL adjacent to another side of the third gate structure (22) before performing the RMG process; and
forming a third hard mask on the third gate structure (22) and a fourth hard mask on the fourth gate structure (26).

8. The method of claim 7, wherein a width of the third hard mask is greater than a width of the third gate structure or wherein a sidewall of the third hard mask is aligned with a sidewall of the third CESL or wherein the method further comprises forming a fifth hard mask on the third hard mask and a sixth hard mask on the fourth hard mask.

9. A semiconductor device, comprising:
a first gate structure (24) on a substrate (12);
an interlayer dielectric, ILD, layer (42) on the first gate structure (24); and
a first hard mask (54) on the first gate structure, wherein a width of the first hard mask is greater than a width of the first gate structure.

10. The semiconductor device of claim 9, wherein the substrate comprises a core region (14), a low noise amplifier, LNA, region (16), an input/output, I/O, region (18), and a power amplifier, PA, region (20), the semiconductor device further comprising:
the first gate structure (24) on the LNA region (16), a second gate structure (28) on the PA region (20), a third gate structure (22) on the core region (14), and a fourth gate structure (26) on the I/O region (16);
the ILD layer (42) on the first gate structure (24), the second gate structure (28), the third gate structure (22), and the fourth gate structure (26); and
a second hard mask on the second gate structure (28).

11. The semiconductor device of claim 10, further comprising:
a first contact etch stop layer, CESL, adjacent to one side of the first gate structure (24) and a second CESL adjacent to another side of the first gate structure.

12. The semiconductor device of claim 11, wherein the width of the first hard mask is greater than a distance between the first CESL to the second CESL.

13. The semiconductor device of claim 10, further comprising:
a third hard mask on the first hard mask (54) and a fourth hard mask on the second hard mask and wherein a width of the first hard mask is equal to a width of the third hard mask.

14. The semiconductor device of claim 10, further comprising:
a third CESL adjacent to one side of the third gate structure (22) and a fourth CESL adjacent to another side of the third gate structure; and
a third hard mask on the third gate structure and a fourth hard mask on the fourth gate structure (26).

15. The semiconductor device of claim 14, wherein a width of the third hard mask is greater than a width of the third gate structure or wherein a sidewall of the third hard mask is aligned with a sidewall of the third CESL or wherein the semiconductor device further comprises a fifth hard mask on the third hard mask and a sixth hard mask on the fourth hard mask.

## Amended claims

### Amended claims in accordance with Rule 137(2) EPC.

1. A method for fabricating a semiconductor device, comprising:
forming a first gate structure (24) on a substrate (12);
forming an interlayer dielectric, ILD, layer (42) on the first gate structure;
wherein the method further comprises:
forming a gate extension material layer (54) on the ILD layer (42) to cover the first gate structure (24); and
conducting a photo-etching process to remove part of the gate extension material layer (54) to form a first gate extension (54) on the first gate structure (24), wherein a width of the first gate extension (54) is greater than a width of the first gate structure (24).

2. The method of claim 1, wherein the substrate (12) comprises a core region (14), a low noise amplifier, LNA, region (16), an input/output, I/O, region (18), and a power amplifier, PA, region (20), the method further comprising:
forming the first gate structure (24) on the LNA region (16), a second gate structure (28) on the PA region (20), a third gate structure (22) on the core region (14), and a fourth gate structure (26) on the I/O region (16);
forming the ILD layer (42) on the first gate structure (24), the second gate structure (28), the third gate structure (22), and the fourth gate structure (26);
performing a replacement metal gate, RMG, process to transform the first gate structure (24), the second gate structure (28), the third gate structure (22), and the fourth gate structure (26) into a first metal gate, a second metal gate, a third metal gate, and a fourth metal gate; and
forming the first gate extension (54) on the first gate structure (24) and a second hard mask on the second gate structure (28).

3. The method of claim 2, further comprising:
forming a first contact etch stop layer, CESL, part adjacent to one side of the first gate structure (24) and a second CESL part adjacent to another side of the first gate structure (24) before performing the RMG process.

4. The method of claim 3, wherein the width of the first gate extension (54) is greater than a distance between the first CESL part to the second CESL part.

5. The method of claim 2, further comprising:
forming a third hard mask on the first gate extension (54) and a fourth hard mask on the second hard mask.

6. The method of claim 5, wherein a width of the first gate extension (54) is equal to a width of the third hard mask.

7. The method of claim 2, further comprising:
forming a third CESL part adjacent to one side of the third gate structure (22) and a fourth CESL part adjacent to another side of the third gate structure (22) before performing the RMG process; and
forming a third hard mask on the third gate structure (22) and a fourth hard mask on the fourth gate structure (26).

8. The method of claim 7, wherein a width of the third hard mask is greater than a width of the third gate structure or wherein a sidewall of the third hard mask is aligned with a sidewall of the third CESL part or wherein the method further comprises forming a fifth hard mask on the third hard mask and a sixth hard mask on the fourth hard mask.

9. A semiconductor device, comprising:
a first gate structure (24) on a substrate (12);
an interlayer dielectric, ILD, layer (42) on the first gate structure (24);
wherein the semiconductor device further comprises:
a first gate extension (54) on the first gate structure, wherein a width of the first gate extension is greater than a width of the first gate structure (24), and four sidewalls or four edges of the first gate structure (24) do not surpass four sidewalls or four edges of the first gate extension (54).

10. The semiconductor device of claim 9, wherein the substrate comprises a core region (14), a low noise amplifier, LNA, region (16), an input/output, I/O, region (18), and a power amplifier, PA, region (20), the semiconductor device further comprising:
the first gate structure (24) on the LNA region (16), a second gate structure (28) on the PA region (20), a third gate structure (22) on the core region (14), and a fourth gate structure (26) on the I/O region (16);
the ILD layer (42) on the first gate structure (24), the second gate structure (28), the third gate structure (22), and the fourth gate structure (26); and
a second hard mask on the second gate structure (28).

11. The semiconductor device of claim 10, further comprising:
a first contact etch stop layer, CESL, part adjacent to one side of the first gate structure (24) and
a second CESL part adjacent to another side of the first gate structure.

12. The semiconductor device of claim 11, wherein the width of the first gate extension is greater than a distance between the first CESL part to the second CESL part.

13. The semiconductor device of claim 10, further comprising:
a third hard mask on the first gate extension (54) and a fourth hard mask on the second hard mask and wherein a width of the first gate extension is equal to a width of the third hard mask.

14. The semiconductor device of claim 10, further comprising:
a third CESL part adjacent to one side of the third gate structure (22) and a fourth CESL part adjacent to another side of the third gate structure; and
a third hard mask on the third gate structure and a fourth hard mask on the fourth gate structure (26).

15. The semiconductor device of claim 14, wherein a width of the third hard mask is greater than a width of the third gate structure or wherein a sidewall of the third hard mask is aligned with a sidewall of the third CESL part or wherein the semiconductor device further comprises a fifth hard mask on the third hard mask and a sixth hard mask on the fourth hard mask.
